# EUROPÄISCHE PATENTSCHRIFT

(11) **EP 1 649 412 B1**
(45) Veröffentlichungstag und Bekanntmachung des Hinweises auf die Patenterteilung: **29.10.2008**
(21) Anmeldenummer: 04738809.5
(22) Anmeldetag: 28.06.2004
(51) Int. Cl.: G06K 19/077, H01L 23/498

(54) **CHIPKARTE, CHIPKARTENMODUL SOWIE VERFAHREN ZUR HERSTELLUNG EINES CHIPKARTENMODULS**
CHIP CARD, CHIP CARD MODULE AND METHOD FOR THE PRODUCTION OF A CHIP CARD MODULE
CARTE A PUCE, MODULE DE CARTES A PUCE, ET PROCEDE DE FABRICATION D'UN MODULE DE CARTES A PUCE

(30) Priorität: 28.07.2003 DE 10334578
(43) Veröffentlichungstag der Anmeldung: 26.04.2006
(73) Patentinhaber: Infineon Technologies AG, 81669 München (DE)
(72) Erfinder: WÖRNER, Holger, 93049 Regensburg (DE); FÜRGUT, Edward, 86453 Dasing (DE); GOLLER, Bernd, 83624 Otterfing (DE); POHL, Jens, 93170 Bernhardswald (DE); STROBEL, Peter, 93047 Regensburg (DE); JEREBIC, Simon, 93049 Regensburg (DE); HAGEN, Robert-Christian, 93092 Sarching (DE)
(74) Vertreter: Schäfer, Horst
(86) Internationale Anmeldenummer: PCT/DE2004/001363
(87) Internationale Veröffentlichungsnummer: WO 2005/015488

(56) Entgegenhaltungen:
- DE-A- 4 424 396
- DE-A- 19 845 665
- US-A- 6 013 945

## Beschreibung

Die Erfindung betrifft ein Verfahren zur Herstellung eines solchen Chipkartenmoduls.

Chipkarten und Chipkartenmodule sind seit langer zeit bekannt und beispielsweise in der DE 44 24 396 A1, US 6,013,945 sowie in der DE 195 00 925 A1 beschrieben. Das dort in der Figur 4 gezeigte Chipkartenmodul weist ein Substrat auf, auf dem ein Halbleiterchip und die metallischen Anschlussflächen angeordnet sind, wobei der Halbleiterchip über Bonddrähte mit den Anschlussflächen verbunden ist. Der Halbleiterchip und die Bonddrähte sind von einer sie schützenden Vergussmasse umgeben. Auf der einen Seite des Substrats sind der Halbleiterchip und die metallischen Anschlussflächen angeordnet. Auf der anderen Seite des Substrats befinden sich die Kontaktflächen für den kontaktbehafteten Datenaustausch der Chipkarte. Im Substrat sind Zugangsöffnungen zu den Kontaktflächen ausgespart.

Das dort gezeigte Chipkartenmodul wird in eine Chipkarte eingebaut, indem es in die dort vorgesehene Öffnung eingeführt wird und dort mit dem Kartenkörper verklebt wird.

Bei der Fertigung solcher Chipkartenmodule wird in der Regel so vorgegangen, dass die Halbleiterchips mit ihren aktiven Oberseiten nach oben weisend auf ein Trägerband fixiert werden. Die Fixierung auf dem Trägerband erfolgt in der Regel durch Kleben. Das Trägerband weist an entsprechenden Stellen metallische Flächen auf, deren Unterseite später zur Kontaktierung des Chipkartenmoduls mit den Peripheriegeräten dient. Die Kontaktierung der Anschlussflächen auf den aktiven Oberseiten des Halbleiterchips mit diesen Kontaktflächen erfolgt durch Wire-Bond-Technik.

Das Wire-Bond-Verfahren hat den großen Nachteil, dass die Verwendung von Wire-Bond-Drähten eine Miniaturisierung des Chipkartenmoduls sehr stark beschränkt. Es lassen sich keine Chipkartenmodule mit sehr geringen Bauhöhen erzielen, da die Wire-Bond-Drähte eine nicht zu unterschreitende räumliche Ausdehnung aufweisen.

Des Weiteren ist in der Figur 11 der eingangs erwähnten DE 195 00 925 A1 eine alternative Ausführungsform für ein Chipkartenmodul gezeigt, bei dem die Kontaktflächen und Anschlussflächen von einem Leadframe gebildet werden, auf dem der Halbleiterchip direkt angeordnet ist. Es wird dort gezeigt, dass der Halbleiterchip mit seinen Anschlussflächen mittels Flip-Chip-Kontaktierung direkt auf den entsprechenden Kontaktflächen und den Anschlussflächen elektrisch leitend fixiert ist. Die dort gemachten Ausführungen machen deutlich, dass es sich bei dem in der Figur 11 gezeigten Chipkartenmodul um eine Ausführung im so genannten "Chip Scale Package" handelt. "Chip Scale Packaging" wird auch oft unter Abkürzung "CSP" geführt. Beim CSP, das eine Unterart Flip-Chip-Technologie ist, werden auf die aktive Oberseite der Halbleiterchips direkt Leiterbahnen gezogen, und auf diese Leiterbahnen dann direkt die Lötkugeln, mit denen der Halbleiterchip dann auf ein Substrat befestigt wird.

Ein großer Nachteil der CSP-Technologie ist jedoch, dass die zur Verfügung stehende aktive Oberseite der Halbleiterchips in der Regel nicht genug Fläche bietet, um alle notwendigen externen Kontakte herzustellen. Des weiteren ist die CSP-Technologie für das Fertigen von chipkartenmodulen schon deswegen ungeeignet, da gerade die Halbleiterchips, die in Chipkartenmodulen Verwendung finden einer extrem starken Miniaturisierung, d. h. einem extrem starken "shrink", unterliegen.

Eine Verarbeitung von Chipkarten-Mikrocontrollern in CSP-Technologie zur Herstellung von Chipkartenmodulen, wie in der DE 195 00 925 A1 vorgeschlagen, scheint daher keine gangbare Lösung.

Aufgabe der vorliegenden Erfindung ist es daher, ein brauchbares großtechnisches Verfahren anzugeben, um die in Wire-Bond-Technologie hergestellten Chipkartenmodule durch neuartige Chipkartenmodule, die gegenüber diesen in ihrer Bauhöhe stark reduziert sind, effizient herzustellen.

Erfindungsgemäß wird die obige Aufgabe durch ein Verfahren zum Herstellen eines Chipkartenmoduls nach Anspruch 1 gelöst, bei dem ein Chipkartenmodul mit folgenden Merkmalen hergestellt wird:
- einem Halbleiterchip mit einer Rückseite, mit einer aktiven Oberseite und mit Seitenflächen;
- einer den Halbleiterchip umhüllenden Kunststoffgehäusemasse, die zumindest eine Oberfläche aufweist, die koplanar zu der aktiven Oberseite des Halbleiterchips ist;
- einer ersten dielektrischen Schicht, die auch diese Oberfläche und auf der aktiven Oberseite des Halbleiterchips angeordnet ist;
- einer oder mehrerer über weitere dielektrische Schichten getrennte Umverdrahtungsmetallisierungsebenen, die mit der aktiven Oberseite des Halbleiterchips verbunden sind; und
- Außenkontaktflächen, die auf der äußersten Umverdrahtungsebene ausgebildet sind, auf die eine Kontaktmetallisierung für eine kontaktbehaftete Datenübertragung aufgebracht ist.

Dieses Chipkartenmodul zeichnet sich durch eine sehr geringe Bauhöhe aus und weist nicht die Problematik des Chipscale Packages auf, da bei einem solchen Chipkartenmodul Umverdrahtungsebenen vorgesehen sind.

Mit diesem Chipkartenmodul lassen sich Chipkarten zur kontaktbehafteten Datenübertragung herstellen, die aus einem Kartenkörper und einem in dem Kartenkörper eingebauten obigen Chipkartenmodul bestehen.

Nach der vorliegenden Erfindung werden die oben erwähnten Chipkartenmodule mit einem Verfahren hergestellt, bei dem zunächst ein Halbleiterwafer mit in Zeilen und Spalten angeordneten Halbleiterchips bereitgestellt wird. Die Halbleiterchips weisen Rückseiten und aktive Oberseiten auf, wobei die aktiven Oberseiten mit inneren Kontaktflächen versehen sind. Diese inneren Kontaktflächen werden auch Kontaktpads genannt.

Danach wird der Halbleiterwafer in einzelne Halbleiterchips getrennt. Die Halbleiterchips werden dann auf einer Trägervorrichtung aufgebracht, wobei die einzelnen Halbleiterchips mit ihren aktiven Oberseiten auf die Oberseite der Trägervorrichtung gebracht werden. Danach wird eine Kunststoffgehäusemasse auf die Trägervorrichtung aufgebracht, so dass ein gemeinsamer Träger aus Kunststoffgehäusemasse entsteht, wobei die Halbleiterchips in die Kunststoffgehäusemasse eingebettet werden. Die Trägervorrichtung wird danach entfernt und auf die nun freiliegenden aktiven Oberseiten der Halbleiterchips, die in eine Matrix von Kunststoff eingebettet sind, wird eine erste dielektrische Schicht aufgebracht, die nun die aktiven Oberseiten der Halbleiterchips und die freiliegenden Oberflächen der vergossenen Kunststoffgehäusemasse bedeckt.

Auf diese abgeschiedene erste dielektrische Schicht werden nun zumindest eine oder mehrere über weitere dielektrische Schichten getrennte Umverdrahtungsmetallisierungsebenen abgeschieden. Die äußerste Umverdrahtungsmetallisierungsebene weist dann Außenkontaktflächen auf, auf die dann die Kontaktmetallisierung aufgebracht wird, die für den kontaktbehafteten Datenaustausch der Chipkarte mit ihrer Peripherie dient. Als letzter Schritt wird der gemeinsame Träger aus Kunststoffgehäusemasse in einzelne Chipkartenmodule zertrennt.

In einer typischen Ausgestaltung der vorliegenden Erfindung wird der gemeinsame Träger aus Kunststoffgehäusemasse auf der Trägervorrichtung mittels Spritzgussverfahren unter zu Hilfenahme eines Formwerkzeuges vorgenommen.

Das Herstellen des gemeinsamen Trägers aus Kunststoffgehäusemasse kann auch im Schleudergussverfahren erfolgen.

Das Aufbringen der Umverdrahtungsmetallisierungsebenen auf den gemeinsamen Träger aus Kunststoffgehäusemasse kann durch Aufbringen einer geschlossenen Metallschicht und anschließende Strukturierung der Metallschicht mittels Fotolacktechnik erfolgen.

In einer weiteren Ausgestaltung der vorliegenden Erfindung werden die Umverdrahtungsmetallisierungsebenen auf den gemeinsamen Träger aus Kunststoffgehäusemasse durch Drucktechnik, insbesondere durch Siebdrucktechnik aufgebracht.

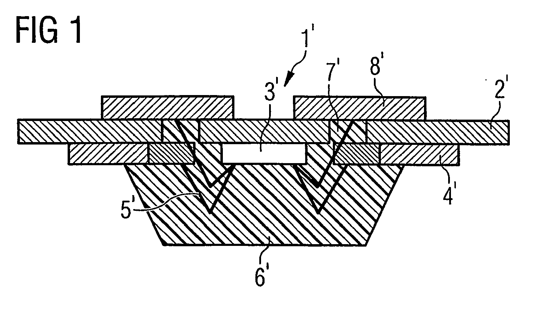

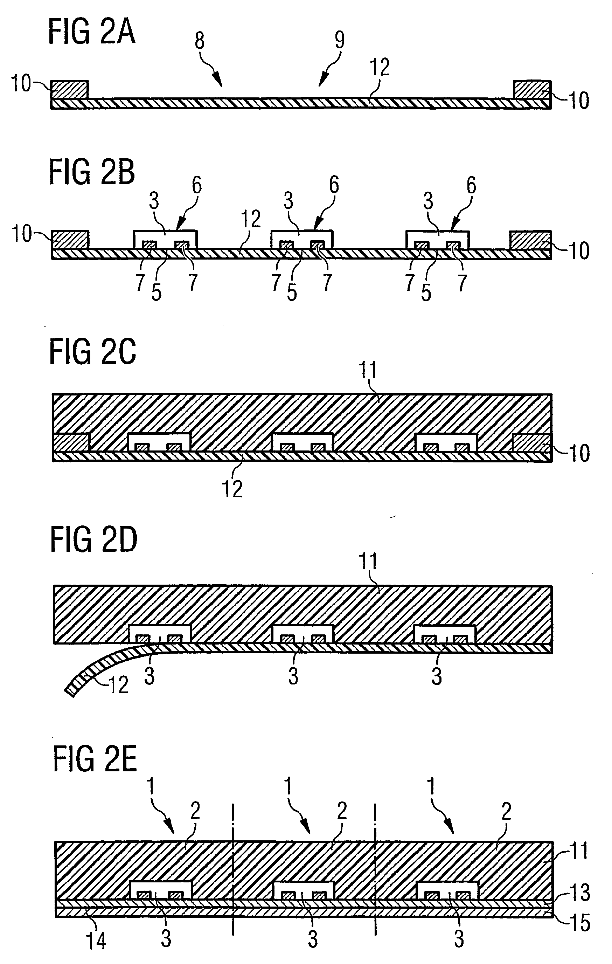

Die Erfindung wird nun anhand von einem Ausführungsbeispiel mit Bezug auf die beiliegenden Zeichnungen näher erläutert. Die Figur 1 zeigt ein Chipkartenmodul aus dem Stand der Technik. Die Figuren 2a bis 2e zeigen seitliche Querschnittansichten von einem Verfahrensablauf zur Ausbildung eines Chipkartenmoduls 1 mit einem Kunststoffgehäuse 2 hergestellt mit einem Verfahren nach der vorliegenden Erfindung.

Die Figur 1 zeigt ein Chipkartenmodule 1', das ein elektrisch isolierendes Substrat 2' aufweist, auf dem ein Halbleiterchip 3' angeordnet ist. Des Weiteren weist das Chipkartenmodul 1' metallische Anschlussflächen 4' auf, wobei der Halbleiterchip 3' über Bonddrähte 5' mit den Anschlussflächen 4' verbunden ist. Der Halbleiterchip 3' und die Bonddrähte 5' sind von einer sie schützenden Kunststoffvergussmasse 6' umgeben. Auf der einen Seite des elektrisch isolierenden Substrats 2' sind der Halbleiterchip 3' und die metallischen Anschlussflächen 4' angeordnet. Auf der anderen Seite des Substrats 2' sind die Kontaktflächen 8' für einen kontaktbehafteten Datenaustausch des Chipkartenmoduls 1' mit seiner Peripherie angeordnet. In dem elektrisch isolierenden Substrat 2' sind zugangsöffnungen 7' zu den Kontaktflächen 8' ausgespart. Der Figur 1 ist unmittelbar zu entnehmen, dass die Bonddrähte 5' den das Bauvolumen begrenzenden Faktor ausmachen.

Die vorliegende Erfindung wird nun anhand der Figuren 2a bis 2e sowohl bezüglich des Chipkartenmoduls als auch des erfindungsgemäßen Verfahrens diskutiert.

Wie aus der Figur 2a ersichtlich ist, wird zunächst eine Trägervorrichtung 8 bereitgestellt, die im vorliegenden Fall aus einem Trägerrahmen 10 und einer Klebefolie 12 besteht.

Aus der Figur 2b ist zu entnehmen, dass anschließend die Trägervorrichtung 8 mit Halbleiterchips 3 bestückt wird. Die Halbleiterchips 3 werden dabei mit ihren aktiven Oberseiten 5 auf die Oberseite 9 der Klebefolie 12 aufgebracht. Dem geht voraus, dass ein fertig prozessierter Halbleiterwafer 4 bereitgestellt wird, der in Zeilen und Spalten angeordnete Halbleiterchips 3 aufweist. Die Halbleiterchips 3 weisen aktive Oberseiten 5 und Rückseiten 6 auf, wobei die aktiven Oberseiten 5 mit Kontaktflächen 7 versehen sind.

Der Halbleiterwafer 4 wird anschließend in einzelne Halbleiterchips 3 getrennt, beispielsweise durch Sägen.

Danach werden die Halbleiterchips 3 mit einer Kunststoffgehäusemasse umhüllt, so dass ein gemeinsamer Träger 11 aus Kunststoffgehäusemasse auf der Trägervorrichtung 8 ausgebildet wird, in den die Halbleiterchips 3 eingebettet sind. Dies ist der Figur 2c zu entnehmen. Das Umhüllen der einzelnen Halbleiterchips 3 kann dabei im Wafermolding im Schablonendruckverfahren, in herkömmlichen Vergussverfahren, in Spin-On-Verfahren sowie in Coating-Verfahren erfolgen.

Als weiterer Schritt findet dann, was der Figur 2d zu entnehmen ist, das Abziehen der auflaminierten Klebefolie 12 statt, nachdem die Kunststoffgehäusemasse ausgehärtet ist. Dabei wird nun zunächst der Trägerrahmen 10 entfernt und die auf dem gemeinsamen Träger aus Kunststoffgehäusemasse 11 haftende Klebefolie 12 wird entweder abgezogen oder abgeschält.

Als weitere Schritte schließen sich dann, was in der Figur 2e angedeutet ist, die Ausbildung von Umverdrahtungsmetallisierungen 13, von Außenkontaktflächen 14 sowie das Aufbringen der als Kontaktmetallisierung 15, die für die kontaktbehaftete Datenübertragung der Chipkarte mit ihren Auslesegeräten dient.

Anschließend wird der gemeinsame Träger 11 zerteilt, was in der Figur 2e durch strichpunktierte Linien angedeutet ist, so daß einzelne Chipkartenmodule 1 mit einem Kunststoffgehäuse 2 vorliegen.

## Patentansprüche

1. Verfahren zum Herstellen eines Chipkartenmoduls (1) mit einem Kunststoffgehäuse (2), in dem zumindest ein Halbleiterchip (3) angeordnet ist, mit folgenden Schritten:
- Bereitstellen eines Halbleiterwafers (4) mit in Zeilen und Spalten angeordneten Halbleiterchips (3), die Rückseiten (6) und aktive Oberseiten (5) aufweisen, wobei die aktiven Oberseiten (5) mit inneren Kontaktflächen (7) versehen sind;
- Trennen des Halbleiterwafers (4) in einzelne Halbleiterchips (3);
- Bestücken einer Trägervorrichtung (8) mit den einzelnen Halbleiterchips (3), wobei die einzelnen Halbleiterchips (3) mit ihren aktiven Oberseiten (5) auf die Oberseite (9) der Trägervorrichtung (8) gebracht werden;
- Herstellen eines gemeinsamen Trägers (11) aus Kunststoffgehäusemasse auf der Trägervorrichtung (8), wobei die Halbleiterchips (3) in die Kunststoffgehäusemasse eingebettet werden;
- Entfernen der Trägervorrichtung (8);
- Abscheiden einer ersten dielektrischen Schicht auf die die aktiven Oberseiten der Halbleiterchips beinhaltende Oberfläche des gemeinsamen Trägers (11);
- Abscheiden einer oder mehrerer über weitere dielektrische Schichten getrennte Umverdrahtungsmetallisierungsebenen (13) auf der ersten dielektrischen Schicht;
- Aufbringen einer Kontaktmetallisierung (15) für eine kontaktbehaftete Datenübertragung auf die Außenkontaktflächen (14) der äußersten Umverdrahtungsmetallisierungsebene (13);
- Trennen des gemeinsamen Trägers (11) in einzelne Chipkartenmodule (1).

2. Verfahren nach Anspruch 1, **dadurch gekennzeichnet, dass** das Herstellen eines gemeinsamen Trägers (11) aus Kunststoffgehäusemasse (2) für die Halbleiterchips (3) auf der Trägervorrichtung (8) durch Spritzgusstechnik mit Hilfe eines Formwerkzeugs erfolgt.

3. Verfahren nach einem der Ansprüche 1 oder 2, **dadurch gekennzeichnet, dass** das Herstellen eines gemeinsamen Trägers (11) aus Kunststoffgehäusemasse (2) für die Halbleiterchips (3) auf der Trägervorrichtung (8) durch Schleudergusstechnik erfolgt.

4. Verfahren nach einem der Ansprüche 1 bis 3, **dadurch gekennzeichnet, dass** das Aufbringen von Umverdrahtungsmetallisierungsebenen (13) auf den gemeinsamen Träger (11) aus Kunststoffgehäusemasse (2) durch Aufbringen einer geschlossenen Metallschicht und anschließende Strukturierung der Metallschicht mittels Fotolacktechnik erfolgt.

5. Verfahren nach einem der Ansprüche 1 bis 4, **dadurch gekennzeichnet, dass** das Aufbringen von Umverdrahtungsmetallisierungsebenen (13) auf den gemeinsamen Träger (11) aus Kunststoffgehäusemasse (2) durch Drucktechnik, insbesondere durch Siebdrucktechnik, erfolgt.

## Claims

1. Method for production of a chip card module (1) having a plastic housing (2) in which at least one semiconductor chip is arranged, having the following steps:
- production of a semiconductor wafer (4) with semiconductor chips (3) which are arranged in rows and columns and have rear faces (6) and active upper faces (5), wherein the active upper faces (5) is provided with inner contact surfaces (7);
- separation of the semiconductor wafer (4) into individual semiconductor chips (3);
- fitting of a mount apparatus (8) with the individual semiconductor chips (3), wherein the individual semiconductor chips (3) are positioned with their active upper faces (5) on the upper face (9) of the mount apparatus (8);
- production of a common mount (11) composed of plastic housing compound on the mount apparatus (8), wherein the semiconductor chips (3) are embedded in the plastic housing compound;
- removal of the mount apparatus (8);
- deposition of a first dielectric layer on that surface of the common mount (11) which includes the active upper faces of the semiconductor chips;
- deposition of one or more interposer metallization levels (13), which are isolated via further dielectric layers, on the first dielectric layer;
- application of contact metallization (15) for contact data transmission to the external contact surfaces (14) of the outermost interposer metallization level (13);
- separation of the common mount (11) into individual chip card modules (1).

2. Method according to Claim 1, **characterized in that** the production of a common mount (11) composed of plastic housing compound (2) for the semiconductor chips (3) on the mount apparatus (8) is carried out by injection molding with the aid of a mold.

3. Method according to one of Claims 1 or 2, **characterized in that** the production of a common mount (11) composed of plastic housing compound (2) for the semiconductor chips (3) on the mount apparatus (8) is carried out by centrifugal casting.

4. Method according to one of Claims 1 to 3, **characterized in that** the application of interposer metallization levels (13) on the common mount (11) composed of plastic housing compound (2) is carried out by application of a closed metal layer and subsequent structuring of the metal layer by means of a photoresist technique.

5. Method according to one of Claims 1 to 4, **characterized in that** the application of the interposer metallization levels (13) to the common mount (11) composed of plastic housing compound (2) is carried out by a printing technique, in particular by screen printing.

## Revendications

1. Procédé de fabrication d'un module (1) de carte à puce qui présente un boîtier (2) en matière plastique dans lequel au moins une puce semi-conductrice (3) est disposée, ledit procédé comprenant les étapes qui consistent à :
- préparer une plaquette semi-conductrice (4) qui présente des puces semi-conductrices (3) qui sont disposées en lignes et en colonnes et qui présentent des côtés arrières (6) et des côtés supérieurs actifs (5), les côtés supérieurs actifs (5) étant dotés des surfaces intérieures de contact (7);
- découper la plaquette semi-conductrice (4) en puces semi-conductrices (3) séparées;
- placer les puces semi-conductrices (3) séparées sur un dispositif de support (8), les puces semi-conductrices (3) séparées étant placées sur le côté supérieur (9) du dispositif de support (8) par leurs côtés supérieurs actifs (5);
- fabriquer un support commun (11) en une pâte de boîtier en matière plastique sur le dispositif de support (8), les puces semi-conductrices (3) étant encastrées dans la pâte de boîtier en matière plastique;
- enlever le dispositif de support (8);
- déposer une première couche diélectrique sur la surface du support commun (11) qui contient les côtés supérieurs actifs des puces semi-conductrices;
- déposer sur la première couche diélectrique un ou plusieurs niveaux de métallisation de câblage (13) séparés par des couches diélectriques supplémentaires,
- appliquer une métallisation de contact (15) pour le transfert de données par contact sur les surfaces extérieures de contact (14) du niveau le plus extérieur de métallisation de câblage (13);
- diviser le support commun (11) en modules (1) de carte à puce séparés.

2. Procédé selon la revendication 1, **caractérisé en ce que** la fabrication d'un support commun (11) en pâte de boîtier (2) en matière plastique pour les puces semi-conductrices (3) sur le dispositif de support (8) s'effectue par moulage par injection à l'aide d'un outil de moulage.

3. Procédé selon l'une des revendications 1 ou 2, **caractérisé en ce que** la fabrication d'un support commun (11) en pâte de boîtier (2) en matière plastique pour les puces semi-conductrices (3) sur le dispositif de support (8) s'effectue par coulée centrifuge.

4. Procédé selon l'une des revendications 1 à 3, **caractérisé en ce que** l'application des niveaux de métallisation de câblage (13) sur le support commun (11) en pâte de boîtier (2) en matière plastique s'effectue par application d'une couche métallique fermée et ensuite structuration de la couche métallique par une technique de photo-vernis.

5. Procédé selon l'une des revendications 1 à 4, **caractérisé en ce que** l'application des niveaux de métallisation de câblage (13) sur le support commun (11) en pâte de boîtier (2) en matière plastique s'effectue par impression et en particulier par sérigraphie.
